# EUROPEAN PATENT APPLICATION

(11) **EP 4 411 797 A1**
(43) Date of publication of application: **07.08.2024**
(21) Application number: 22875190.5
(22) Date of filing: 30.09.2022
(51) Int. Cl.: H01L 21/687, H01L 21/677

(54) **GRABBING DEVICE AND OVERHEAD CONVEYANCE VEHICLE**

(30) Priority: 30.09.2021 CN 202111166784
(71) Applicant: Meetfuture Technology (Shanghai) Co., Ltd., Shanghai 200131 (CN)
(72) Inventor: DU, Baobao, Shanghai 200131 (CN); MIAO, Feng, Shanghai 200131 (CN)
(74) Representative: Balder IP Law, S.L.
(86) International application number: PCT/CN2022/123436
(87) International publication number: WO 2023/051810

(57) **Abstract**

The present application provides a grasping device and an overhead hoist vehicle applied in the technical field of automatic control. The grasping device includes a base plate (1), an electric motor (2), a bidirectional lead screw (3), a first support seat (4), a second support seat (5), a first clamping mechanism (6), a second clamping mechanism (7), and a first sensing detection portion (8). The electric motor (2) is configured to drive the bidirectional lead screw (3), and the bidirectional lead screw (3) drives the first clamping mechanism (6) and the second clamping mechanism (7) to move. The first sensing detection portion (8) is configured to detect a relative position between the first clamping mechanism (6) and the second clamping mechanism (7), and trigger the electric motor (2) to stop outputting in response to the relative position meeting a first preset position.

## Description

The present application is filed based on the Chinese Patent Application No. 202111166784.1 filed on September 30, 2021, and claims the priority of the Chinese patent application, which is incorporated herein by reference in its entirety.

### TECHNICAL FIELD

Embodiments of the present application relate to the technical field of automatic control, more specifically to a semiconductor manufacturing equipment, and in particular to a grasping device and an overhead hoist vehicle including the same.

### BACKGROUND

In a semiconductor manufacturing factory, an overhead hoist vehicle (i.e., overhead travelling crane) configured to transport wafer pods overhead is generally provided with a grasping device (e.g., a grasper) configured to grasp the wafer pods.

In the existing overhead hoist vehicle, the structure of the grasping device is complex and heavy, which occupies a large volume. There are many limitations on the application of the overhead hoist vehicle, such as complex control methods, occupying large amount of overhead space, and requiring the overhead track to withstand the movement of heavier equipment.

Based on this, a technical solution is provided according the present application to solve the above technical problems.

### SUMMARY

A grasping device is provided according to the present application, and the grasping device includes a base plate, an electric motor, a bidirectional lead screw, a first support seat, a second support seat, a first clamping mechanism, a second clamping mechanism, and a first sensing detection portion. The first clamping mechanism includes a first clamping portion, a first connecting plate, a first guide rail and a first nut seat, the second clamping mechanism includes a second clamping portion, a second connecting plate, a second guide rail, and a second nut seat. After the first clamping portion is connected to the first connecting plate, the first clamping portion is installed on the base plate by the first guide rail, and is sleeved on the bidirectional lead screw by the first nut seat. After the second clamping portion is connected to the second connecting plate, the second clamping portion is installed on the base plate by the second guide rail, and is sleeved on the bidirectional lead screw by the second nut seat. The bidirectional lead screw is supported and installed on the base plate by the first support seat and the second support seat. The first sensing detection portion is configured to detect a relative position between the first clamping mechanism and the second clamping mechanism, and trigger the electric motor to stop outputting in response to the relative position meeting a first preset position.

### BRIEF DESCRIPTION OF THE DRAWINGS

The following will provide a clear and understandable explanation of the preferred embodiments in conjunction with the accompanying drawings, and the above features, technical features, advantages, and embodiments are further described.
FIG. 1 is a three-dimensional structural view of a grasping device provided according to the present application;
FIG. 2 is a top view of a grasping device provided according to the present application when a target object is not grasped;
FIG. 3 is a front view of a grasping device provided according to the present application when a target object is not grasped;
FIG. 4 is a three-dimensional structural view of a second sensing detection portion of a grasping device provided according to the present application when a target object is not grasped;
FIG. 5 is a top view of a grasping device provided according to the present application when grasping a target object;
FIG. 6 is a front view of a grasping device provided according to the present application when grasping a target object;
FIG. 7 is a three-dimensional structural view of a second sensing detection portion of a grasping device provided according to the present application when grasping a target object;
FIG. 8 is a three-dimensional structural view of the second sensing detection portion of a grasping device provided according to the present application when abnormally grasping a target object;
FIG. 9 is a three-dimensional structural view of a clamping portion of a grasping device provided according to the present application; and
FIG. 10 is a schematic structural view of a target object used in conjunction with a grasping device provided according to the present application.

### DETAILED DESCRIPTION

In order to provide a clearer explanation of the embodiments of the present application or the technical solutions in the prior art, the specific implementation methods of the present application will be explained below with reference to the accompanying drawings. Obviously, the accompanying drawings in the following description are only some embodiments of the present application. For ordinary technical personnel in this field, other drawings and implementation methods can be obtained based on these drawings without any creative effort.

Based on the present application, those skilled in the art should understand that one aspect described herein can be independently implemented of any other aspect, and that two or more of these aspects can be combined in various ways. For example, any number and aspects described herein can be used to implement equipment and/or practical methods. In addition, other structures and/or functionalities other than those described herein may be used to implement this device and/or practice the method.

It should also be noted that the accompanying drawings provided according to the following embodiments only illustrate the basic concept of the present application in a schematic manner. The figures only display the components related to the present application and are not necessarily drawn based on the actual number, shape, and size of the components during implementation. The type, quantity, and proportion of each component during actual implementation can be arbitrarily changed, and the component layout may also be more complex.

In addition, in the following description, specific details are provided to facilitate a thorough understanding of the example. However, technical personnel in the field will understand that the described aspects can be practiced without these specific details. The terms "first", "second", etc. are only used for the purpose of description and cannot be understood as indicating or implying relative importance or implying the quantity of technical features indicated. Therefore, features with limited descriptions such as "first" and "second" can explicitly or implicitly include one or more of these features. In the description of the present application, unless otherwise specified, "multiple" means two or more.

Wafer pods mainly play a role in storing and transporting wafers in semiconductor production. Using wafer pods not only reduces the risk of wafer contamination, but also improves transportation efficiency. Therefore, a semiconductor manufacturing factory uses wafer pods to transport and store wafers. The wafer pods are generally grasped by the grasping device (e.g., a grasper) of an overhead hoist vehicle (e.g., overhead travelling crane), and then transported by the overhead hoist vehicle to a designated workstation.

In the related technologies of overhead hoist vehicles, according to the different power sources, grasping devices are categorized into a pneumatic grasping device, a hydraulic grasping device, a mechanical grasping device, etc. The existing grasping device has a complex structure, a large volume, and a heavy weight, which has many limitations on the application of the overhead hoist vehicle, such as complex control methods, occupying large amount of overhead space, and requiring the overhead track to withstand the movement of heavier equipment.

The grasping device provided according to the present application has been redesigned, which operates in conjunction with a bidirectional lead screw and an electric motor for grasping or releasing. The grasping device provided according to the present application has a simple structure, small size, light weight, high stability and good safety during grasping or releasing. The grasping device includes an electric motor and a bidirectional lead screw, where the bidirectional lead screw is fixed on a base plate of a grasping mechanism, the electric motor is connected to the bidirectional lead screw. In response to the electric motor being started, the bidirectional lead screw is driven to rotate around its central axis. The grasping device further includes a pair of opposite clamping mechanisms, which are connected to the bidirectional lead screw by a nut seat. In response to the bidirectional lead screw rotating, the clamping mechanisms are driven by the nut seat to move along the bidirectional lead screw, which allows the clamping mechanisms to approach or leave each other to grasp or release the wafer pod. Specifically, in response to the clamping mechanisms approaching each other, a grasping action is performed to grasp the wafer pod. In response to the clamping mechanisms leaving each other, a release action is performed to release the wafer pod. The sensing detection portion is configured to detect a relative position between the clamping mechanisms, and in response to the preset position being met, the electric motor is triggered to stop outputting.

The following is a description of the technical solutions provided by each embodiment of the present application, in conjunction with the accompanying drawings.

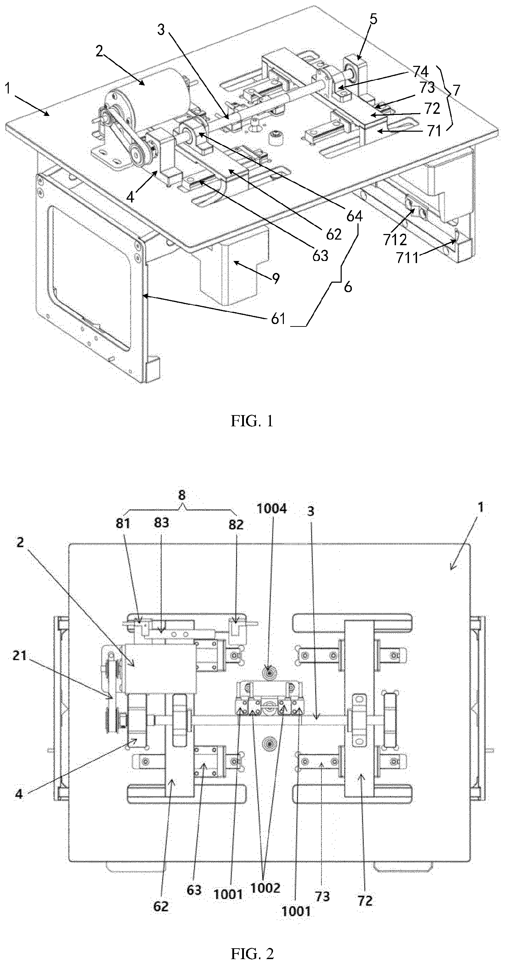

As shown in FIG. 1 to FIG. 3, the grasping device includes a base plate 1, an electric motor 2, a bidirectional lead screw 3, a first support seat 4, a second support seat 5, a first clamping mechanism 6, a second clamping mechanism 7, and a first sensing detection portion 8.

The first clamping mechanism 6 includes a first clamping portion 61, a first connecting plate 62, a first guide rail 63, and a first nut seat 64. The second clamping mechanism 7 includes a second clamping portion 71, a second connecting plate 72, a second guide rail 73, and a second nut seat 74. The first clamping portion 61 is connected to the first connecting plate 62. The first clamping portion 61 is installed on the base plate 1 through the first guide rail 63, and is sleeved on the bidirectional lead screw 3 through the first nut seat 64. Among them, the second clamping portion 71 is connected to the second connecting plate 72, installed on the base plate 1 through the second guide rail 73, and sleeved on the bidirectional lead screw 3 through the second nut seat 74; The bidirectional lead screw 3 is supported and installed on the base plate 1 through the first support seat 4 and the second support seat 5.

The first sensing detection portion 8 is used to detect the relative position between the first clamping mechanism 6 and the second clamping mechanism 7, and trigger the electric motor to stop outputting in response to the relative position meeting the first preset position.

For example, the first preset position is the relative position between the two clamping mechanisms in response to the first clamping mechanism 6 and the second clamping mechanism 7 stably grasping the target object, that is, the first preset position is the final relative position between the first clamping mechanism 6 and the second clamping mechanism 7. In this case, the first sensing detection portion 8 is configured to detect the first preset position, and trigger the electric motor 2 to stop rotating, so that the first clamping mechanism 6 and the second clamping mechanism 7 remain stable in the final position, and the target object is properly grasped.

For example, the first preset position is the relative position between the first clamping mechanism 6 and the second clamping mechanism 7 before clamping the target object, that is, the first preset position is a starting relative position between the first clamping mechanism 6 and the second clamping mechanism 7. In this case, the first sensing detection portion 8 is configured to detect the first preset position, and trigger the electric motor 2 to stop rotating, so that the first clamping mechanism 6 and the second clamping mechanism 7 remain stable in the initial position.

By using the first sensing detection portion 8, the positions of the two clamping mechanisms can be accurately controlled to prevent grasping and clamping process of the target object from being affected during transportation caused by improper position of the clamping mechanisms.

In some embodiments, a bidirectional lead screw (i.e., a left and right rotating lead screw, a front and back tooth lead screw, etc.) is a rod structure with one end having a left rotating screw tooth and one end having a right rotating screw tooth, which can enable the two nuts set on the rod to move in opposite directions simultaneously, which will not be limited thereto.

To facilitate understanding, the grasping process is described in detail, that is, in response to the electric motor 2 working, the electric motor 2 drives the bidirectional lead screw 3, the bidirectional lead screw 3 drives the first nut seat 64 and the second nut seat 74 to move. The first nut seat 64 drives the first clamping portion 61 to move by the first connecting plate 62, and the second nut seat 74 drives the second clamping portion 71 by the second connecting plate 72. Due to the fact that the bidirectional lead screw 3 has two threads with different directions on one lead screw, namely a right-hand thread and a left-hand thread, for example, the right-hand thread can connect to the first nut seat 64 and the left-hand thread can connect to the second nut seat 74, or the left-hand thread can connect to the first nut seat 64 and the right-hand thread can connect to the second nut seat 74. In response to the bidirectional lead screw 3 rotating, the first clamping portion 61 and the second clamping portion 71 approach each other to reach two sides of the wafer pod for grasping and clamping, or the two clamping mechanisms move far away from each other to release the wafer pod to the destination.

In some embodiments, by controlling the operation of the electric motor 2, and providing a first sensing detection portion, the relative distance between the first nut seat 64 and the second nut seat 74 along the bidirectional lead screw 3 can be controlled, so as to be able to grasp objects of different sizes according to the needs of the factory.

In some embodiments, as shown in FIG. 2, a groove is defined on the base plate 1 to allow two arms of the clamping mechanism to pass through the groove and connect to the connecting plate, and the bidirectional lead screw 3 is sleeved through the first nut seat 64 or the second nut seat 74. With this structural design, components such as the electric motor 2 and the bidirectional lead screw 3 are arranged on the opposite side of the base plate 1, which increases the space for performing grasping below the base plate 1 and improves the applicability and convenience of the grasping device.

It should be noted that according to the application needs, components such as the electric motor 2 and the bidirectional lead screw 3 may be both arranged below the base plate 1, that is, the electric motor 2 and the bidirectional lead screw 3 are arranged on the same side as the wafer pod, which will not be elaborated herein.

In some embodiments, the first connecting plate 62 is a U-shaped structure and connected to the first clamping portion 61 through both ends of the U-shaped structure. Similarly, the second connecting plate 72 is also a U-shaped structure, which will not be repeatedly described here.

In some embodiments, the electric motor 2 is connected to bidirectional lead screw 3 by belt 21 (as shown in FIG. 2), or directly connected to the bidirectional lead screw 3 (not shown here). The connection between the electric motor 2 and the bidirectional lead screw 3 can be flexibly arranged according to space requirements, counterweight requirements, and other requirements of design, which will not be limited thereto.

In some embodiments, the first guide rail 63 is installed on the base plate 1, and the first connecting plate 62 is supported on the first guide rail 63. For example, the first connecting plate 62 is connected to a slide rail connection seat on the upper part of the first guide rail 63, so that in response to the electric motor 2 driving the bidirectional lead screw 3 to rotate, the first connecting plate 62 moves along the first guide rail 63. Similarly, the second guide rail 73 is installed on the base plate 1, the second connecting plate 72 is supported on the second guide rail 73, and the second connecting plate 72 moves in the same way as the first connecting plate 62, which will not be repeatedly described here.

The grasping device provided according to the present application can be applied to the overhead hoist vehicle. The grasping device uses an electric motor combined with the first sensing detection portion to drive two clamping mechanisms, which optimizes the structural space and weight, and improves the accuracy of grasping or releasing operations. The first sensing detection portion is configured to detect whether the two clamping mechanisms have reached the position of grasping or releasing the target object such as wafer pods. Through the driving performed by the combination of an electric motor and a bidirectional lead screw, the moving direction and distance of the two clamping mechanisms are controlled, to execute the grasping or releasing action, which simplifies the structure of the grasping device, reduces the volume of the device, and reduces the weight of the device. Moreover, through the first sensing detection portion, the distance between the two clamping mechanisms can be more precisely controlled, thereby more accurately and safely grasping or releasing the target object.

In some embodiments, the first sensing detection portion 8 includes a first sensor 81, a second sensor 82, and a first detection panel 83. Among them, the first detection panel 83 is configured to trigger the first sensor 81 to output a trigger signal or the second sensor 82 to output a trigger signal in response to the relative position meeting the first preset position, and the trigger signal is used to trigger the electric motor to stop outputting.

For example, as shown in FIG. 2, in response to the first detection panel 83 enters a sensing area of the first sensor 81, that is, in response to the grasping device completing the releasing action (i.e., two clamping mechanisms apart from each other), the first sensor 81 is activated, and the first sensor 81 outputs a trigger signal to close the electric motor 2. The grasping device is in a releasing state (i.e., initial position) of not grasping the target object, in order to return to the initial position after releasing the target object, and prepare for the next grasping of the target object.

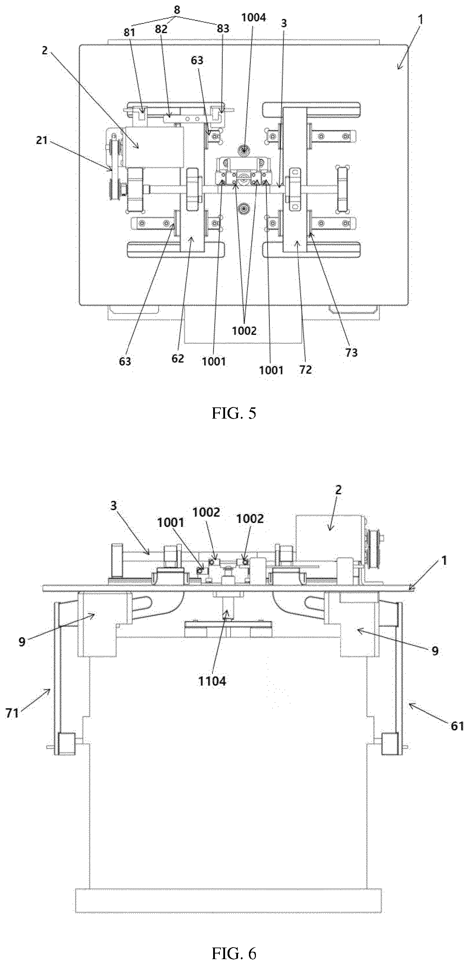

For example, as shown in FIG. 5, in response to the first detection panel 83 entering the sensing area of the second sensor 82, that is, in response to the grasping device completing the grasping action (i.e., two clamping mechanisms approach each other), the second sensor 82 is activated, and the second sensor 82 outputs a trigger signal to turn off the electric motor 2. The grasping device is in a grasping clamping state to stably grasp the target object.

It should be noted that the first sensor 81 is not limited to detecting the releasing state of the grasping device. Similarly, the second sensor 82 is not limited to detecting the grasping state of the grasping device, which can be flexibly set according to actual needs of detecting the state of the grasping device by the first sensor 81 or the second sensor 82.

In some embodiments, the clamping mechanism can be adapted to grasp and hold objects of different volumes by setting different distances between the first sensor 81 and the second sensor 82.

In some embodiments, the first sensor 81 and the second sensor 82 are installed on the base plate 1 and on two opposite sides of the first connecting plate 62, respectively, and the first detection panel 83 is installed on the first connecting plate 62 to move with the first connecting plate 62.

In some embodiments, the first sensor 81 and the second sensor 82 are respectively installed on the base plate 1 and on two opposite sides of the second connecting plate 72, and the first detection panel 83 is installed on the second connecting plate 72 to move with the first connecting plate 72.

In some embodiments, the grasping device further includes a guiding detection mechanism, which includes a second sensing detection portion 10 and multiple guiding blocks 9.

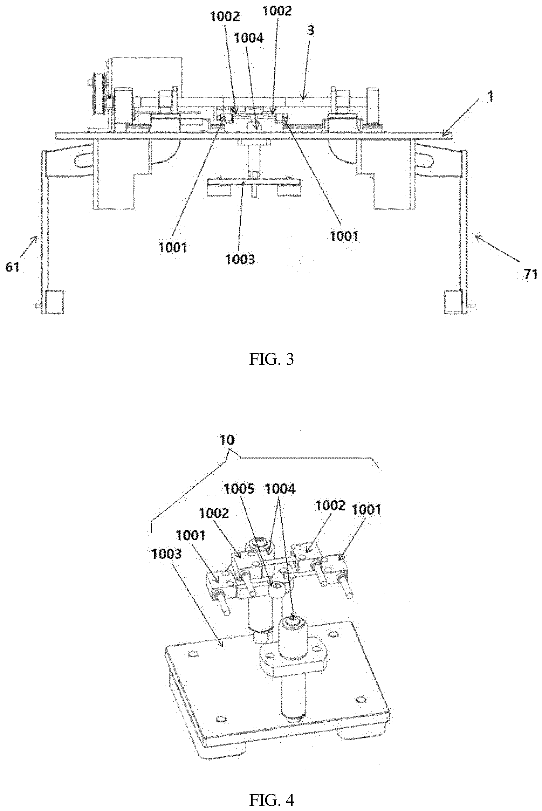

As shown in FIG. 3, four guiding blocks 9 are installed around the bottom of base plate 1 to guide and locate the target object from four top points when grasping the target object. It should be noted that the number and position of guiding blocks can be adjusted based on the top and shape characteristics of the target object, which will not be limited thereto.

The second sensing detection portion 10 is installed on the base plate 1, and a part of the second sensing detection portion 10 (e.g., a plate shaped detection portion or a column shaped detection portion) is arranged on the same side as the target object to perform sensing detection on the target object. The sensing detection includes detecting whether the target object has reached the designated position, the electric motor 2 is triggered to drive the bidirectional lead screw 3 based on the detection results. The first clamping mechanism 6 and the second clamping mechanism 7 moves in opposite directions (close to each other) or apart from each other, in response to the first clamping mechanism 6 and the second clamping mechanism 7 approach each other, the target object is clamped, and in response to the first clamping mechanism 6 and the second clamping mechanism 7 apart from each other, the target object is released.

In some embodiments, as the grasping device gradually approaches the wafer pod (not shown in the figure), a vertex at the upper end of the wafer pod is in contact with the guiding block 9. Under the guidance of the guiding blocks 9, the wafer pod gradually enters the center position of the area composed of the guiding blocks 9. The second sensing detection portion 10 is configured to detect the position information of the target object. In response to the target object reaching the designated grasping member, the second sensing detection portion 10 sends a signal to cause the electric motor 2 to start, which causes the two clamping mechanisms to move towards each other and clamp the wafer pod.

In some embodiments, in response to the wafer pod being in an abnormal situation (not shown in the figure), for example, it is not closed properly, there are foreign objects on the surface, or it is in a horizontally inclined state, the wafer pod in the abnormal situation can also be guided by the guiding blocks 9 and gradually enter the center position of the area composed of the guiding blocks 9. The second sensing detection portion 10 is configured to detect the abnormal position information of the target object, send a signal to cause the electric motor 2 to start, which causes the two clamping mechanisms to apart from each other, so that the wafer pod is released.

As shown in FIG. 4, the second sensing detection portion 10 includes a third sensor 1001, a fourth sensor 1002, a positioning plate 1003, an elastic component 1004, and a detection column 1005.

The third sensor 1001 and the fourth sensor 1002 are respectively installed on the base plate 1, and the fourth sensor 1002 is arranged higher than the third sensor 1001.

In some embodiments, the third sensor 1001 includes a magnetoelectric sensor, a photoelectric sensor. And/or, the fourth sensor 1002 includes a magnetoelectric sensor, a photoelectric sensor, etc.

When using an optoelectronic sensor, the third sensor 1001 includes a first light emitting component and a first light receiving component, where the first light emitting component and the first light receiving component are arranged opposite to each other to form a first through-beam sensing detection component. Similarly, the fourth sensor 1002 includes a second light emitting component and a second light receiving component, where the second light emitting component and the second light receiving component are arranged opposite to each other to form a second through-beam sensing detection component.

The elastic component 1004 and the detection column 1005 are installed on the positioning plate 1003, and the positioning plate 1003 is installed under the bottom surface of the base plate 1 (i.e., on the same side as the target object) through the flange of the elastic component 1004. The detection column 1005 is installed on the positioning plate 1003 to move with the positioning plate 1003 to trigger the generation of detection signals by the third sensor 1001 and/or the fourth sensor 1002. The elastic component 1004 is configured to retract axially and provide reverse elasticity to the positioning plate 1003, which prevent the grasping device from falling excessively after the fourth sensor 1002 generates a detection signal.

In some embodiments, in response to the positioning plate 1003 not being in contact with the target object, as shown in FIG. 3 and FIG. 4, the positioning plate 1003 is in a natural suspension state under the action of gravity, meanwhile the elastic component 1004 is in an extended state. In this case, the top of the detection column 1005 is below the sensing area of the third sensor 1001, and the third sensor 1001 remains operating. Due to the installation height of the fourth sensor 1002 being higher than the third sensor 1001, the top of the detection column 1005 is also below the fourth sensor 1002, and the fourth sensor 1002 remains operating. In this case, the grasping device remains in a released state.

In some embodiments, the top of the detection column 1005 has a head shape such as a screw head or a block, so that the head shape triggers the sensor to output a detection signal when entering the detection area of the sensor. For example, the detection column 1005 may be embodied as a screw.

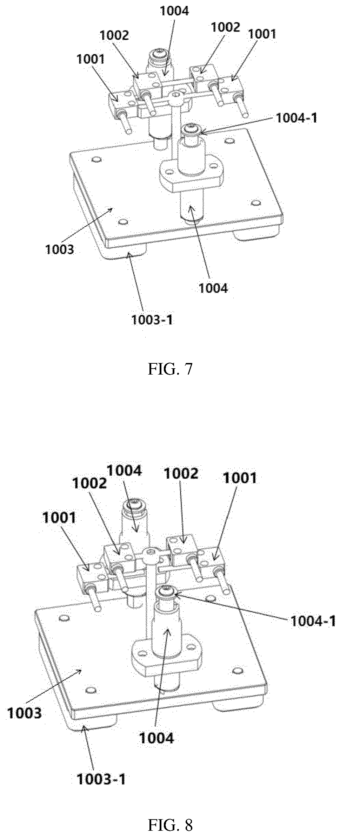

In some embodiments, in response to the positioning plate 1003 being in contact with the target object, as shown in FIG. 6 and FIG. 7, the positioning plate 1003 moves upward under the abutment of the target object, which causes the top of the detection column 1005 to enter the sensing area of the third sensor 1001. The third sensor 1001 turns to a closed state from an open state. In this case, the top of the detection column 1005 is still below the fourth sensor 1002, so only the third sensor 1001 is triggered to output the sensing signal, to represent that the target object meets the grasping condition, so that the grasping device performs the grasping action.

In some embodiments, in response to the wafer pod being in an abnormal situation (not shown in the figure), for example, it is not closed properly, there are foreign objects on the surface, or it is in a horizontally inclined state, the positioning plate 1003 continues to move excessively upward under the abutment of the abnormal target object. As shown in FIG. 8, the top of the detection column 1005 passes through the sensing area of the third sensor 1001 and enters the sensing area of the fourth sensor 1002, so that the third sensor 1001 is not detecting the presence of the detection column 1005, the fourth sensor 1002 is configured to detect the presence of detection column 1005, which can trigger both the third sensor 1001 and the fourth sensor to output sensing signals to represent that the target object does not meet the grasping conditions, and the grasping device stops grasping or performs a releasing action.

It should be noted that in response to the target object being too close to the grasping device in the vertical direction, such as in response to the control device of the overhead hoist vehicle used for lifting and controlling the grasping device failing, the grasping device descends by a distance greater than the predetermined distance. In this case, under the abutment of the target object, the positioning plate 1003 causes the top of the detection column 1005 to pass through the sensing area of the third sensor 1001 and enter the sensing area of the fourth sensor 1002, which can also trigger the sensing signal, to represent that the target object does not meet the grasping conditions.

It should also be noted that the initial state of the third sensor 1001 and/or the fourth sensor 1002 may also be a closed state. In response to the detection column 1005 entering the sensing area, the third sensor 1001 and/or the fourth sensor 1002 turns to an open state from a closed state to output the sensing signal.

In some embodiments, the first clamping portion 61 and/or the second clamping portion 71 further includes a finger plate positioning block 711, and both sides of the finger plate positioning block 711 are provided with inclined surfaces. When performing a grasping action, the end chamfers of the target object are in contact with the inclined surface of the finger plate positioning block 711, and under the guidance of the inclined surface, the target object enters the designated position.

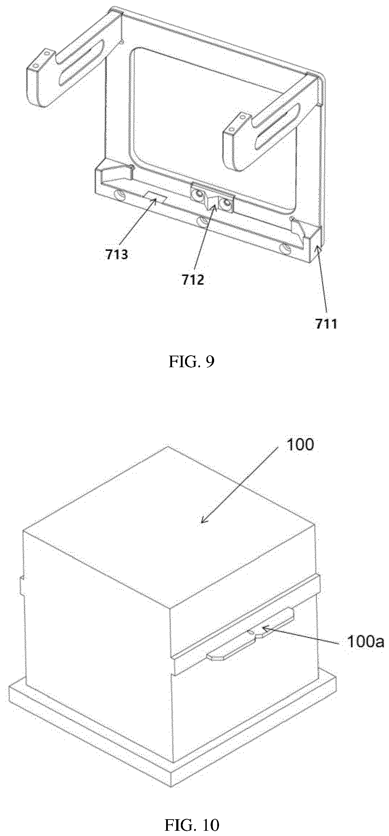

In some embodiments, as shown in FIG. 9 and FIG. 10, the finger plate positioning block 711 is fixed at the inner lower end of the second clamping portion 71, and the endpoint position of the finger plate positioning block 711 is provided with an inclined surface, an arc surface, etc., to perform rough orientation coordination with the two ends of the grasping member 100a of the target object 100, and guide the target object into the designated position. The inclined surfaces are defined on two opposite sides of the grasping member 100a, which cooperate with the inclined surfaces of the finger plate positioning block 711.

In some embodiments, the first clamping portion 61 and/or the second clamping portion 71 further includes a V-shaped positioning block, with a V-shaped opening preset on the target object. The V-shaped positioning block cooperates with the V-shaped opening to guide the target object into a designated position.

In some embodiments, as shown in FIG. 9, the V-shaped positioning block 712 is located on the inner side of the second clamping portion 71, and the V-shaped positioning block forms an outward protrusion V-shaped structure. As shown in FIG. 10, the side of the target object 100 is equipped with a grasping member 100a, and a V-shaped opening is opened on the grasping member 100a for precise directional matching with the V-shaped positioning block. The V-shaped positioning block can fit into the V-shaped opening for precise directional positioning.

In some embodiments, the first clamping portion 61 and/or the second clamping portion 71 further includes a fifth sensor 713. For example, the fifth sensor 713 is installed on the finger plate positioning block 711, and the fifth sensor 713 is configured to detect whether the target object is clamped by the clamping portion.

In some embodiments, the fifth sensor 713 is installed on the finger plate positioning block 711, and the fifth sensor 713 is a pressure sensor. In response to the fifth sensor 713 being in contact with the grasping member 100a of the target object 100, the fifth sensor 713 is configured to output a sensing signal to represent that the target object is grasped. The fifth sensor 713 may also be a light sensor, and in response to the fifth sensor 713 being obstructed by the grasping member 100a of the target object 100, the fifth sensor 713 is configured to output a sensing signal to represent that the target object is grasped.

Based on the same invention concept, an overhead hoist vehicle is further provided according to the embodiments of the present application, and the overhead hoist vehicle includes the grasping device according to any of the above embodiments, a lifting belt, and a control system. The lifting belt is connected to the base plate of the grasping device, and the control system is configured to control the lifting belt to extend or retract to enable the grasping device to grasp the target object. After the target object is grasped by the grasping device, the target object is lifted and transported to the designated position.

It should be noted that the above embodiments can be freely combined as needed. The above are only the preferred embodiments of the present application. It should be pointed out that for those of ordinary skills in the art, several improvements and modifications may be made without departing from the principles of the present application. These improvements and modifications shall fall within the scope of protection of the present application.

## Claims

1. A grasping device applied to an overhead hoist vehicle, comprising a base plate (1), an electric motor (2), a bidirectional lead screw (3), a first support seat (4), a second support seat (5), a first clamping mechanism (6), a second clamping mechanism (7), and a first sensing detection portion (8), wherein the first clamping mechanism (6) comprises a first clamping portion (61), a first connecting plate (62), a first guide rail (63) and a first nut seat (64), the second clamping mechanism (7) comprises a second clamping portion (71), a second connecting plate (72), a second guide rail (73), and a second nut seat (74);
wherein after the first clamping portion (61) is connected to the first connecting plate (62), the first clamping portion (61) is installed on the base plate (1) by the first guide rail (63), and is sleeved on the bidirectional lead screw (3) by the first nut seat (64);
wherein after the second clamping portion (71) is connected to the second connecting plate (72), the second clamping portion (71) is installed on the base plate (1) by the second guide rail (73), and is sleeved on the bidirectional lead screw (3) by the second nut seat (74);
wherein the bidirectional lead screw (3) is supported and installed on the base plate (1) by the first support seat (4) and the second support seat (5); and
wherein the first sensing detection portion (8) is configured to detect a relative position between the first clamping mechanism (6) and the second clamping mechanism (7), and trigger the electric motor (2) to stop outputting in response to the relative position meeting a first preset position.

2. The grasping device according to claim 1, wherein the first sensing detection portion (8) comprises a first sensor (81), a second sensor (82), and a first detection panel (83); the first detection panel (83) is configured to trigger the first sensor (81) to output a trigger signal or trigger the second sensor (82) to output a trigger signal in response to the relative position meeting the first preset position, and the trigger signal is used to trigger the electric motor (2) to stop outputting.

3. The grasping device according to claim 2, wherein the first sensor (81) and the second sensor (82) are installed on the base plate (1) and located on two opposite sides of the first connecting plate (62), respectively; and
wherein the first detection panel (83) is installed on the first connecting plate (62) to move with the first connecting plate (62).

4. The grasping device according to claim 1, further comprising a guiding detection mechanism, wherein the guiding detection mechanism comprises a second sensing detection portion (10) and a plurality of guiding blocks (9);
wherein the plurality of guiding blocks (9) are installed under the base plate (1) to perform first guiding positioning in grasping a target object; and
wherein the second sensing detection portion (10) is configured to sense and detect the target object in response to the first guiding positioning reaching a second preset position, and trigger the electric motor (2) to drive the bidirectional lead screw (3) based on detecting results, so that the first clamping mechanism (6) and the second clamping mechanism (7) move to face to or leave each other, in response to the first clamping mechanism (6) and the second clamping mechanism (7) move to face each other, the target object is clamped, and in response to the first clamping mechanism (6) and the second clamping mechanism (7) move to leave each other, the target object is released.

5. The grasping device according to claim 4, wherein the second sensing detection portion (10) comprises a third sensor (1001), a fourth sensor (1002), a positioning plate (1003), an elastic component (1004), and a detection column (1005);
wherein the third sensor (1001) and the fourth sensor (1002) are installed on the base plate (1), respectively, and the fourth sensor (1002) is arranged higher than the third sensor (1001);
wherein the elastic component (1004) and the detection column (1005) are installed on the positioning plate (1003), and the positioning plate (1003) is installed under the base plate (1) by the elastic component (1004);
wherein the positioning plate (1003) is subjected to gravity, to cause the detection column (1005) to be in a first detection position located below a sensing area of the third sensor (1001); and
wherein in response to the plurality of guiding blocks (9) being used in first guiding positioning, the positioning plate (1003) is in contact with a positioning position on the target object, and the detection column (1005) abuts against the target object to enable the detection column (1005) to enter the sensing area of the third sensor (1001) to trigger the third sensor (1001) to output a first sensing signal, so that a position of the target object meets a first grasping condition; and
in response to the positioning plate (1003) being abutted against the target object, the detection column (1005) is configured to leave the sensing area of the third sensor (1001) and enter a sensing area of the fourth sensor (1002), and trigger the third sensor (1001) to output a second sensing signal and trigger the fourth sensor (1002) to output a third sensing signal, so that the position of the target object meets a second grasping condition.

6. The grasping device according to claim 5, wherein the third sensor (1001) comprises a first light emitting component and a first light receiving component arranged opposite to each other; and
wherein the fourth sensor (1002) comprises a second light emitting component and a second light receiving component arranged opposite to each other.

7. The grasping device according to claim 1, wherein at least one of the first clamping portion (61) or the second clamping portion (71) comprises a finger plate positioning block, and both sides of the finger plate positioning block are provided with inclined surfaces to guide and locate the target object in response to at least one of the first clamping portion (61) or the second clamping portion (71) being in contact with the target object.

8. The grasping device according to claim 7, wherein at least one of the first clamping portion (61) or the second clamping portion (71) further comprises a V-shaped positioning block configured to guide and position with a V-shaped opening preset on the target object.

9. The grasping device according to claim 7, wherein at least one of the first clamping portion (61) or the second clamping portion (71) further comprises a fifth sensor (713) installed on the finger plate positioning block, and the fifth sensor (713) is configured to detect whether the clamping portion holds the target object or not.

10. An overhead hoist vehicle, comprising a grasping device, a lifting belt, and a control system, wherein the grasping device is the grasping device according to any one of claims 1 to 9, the lifting belt is connected to a base plate of the grasping device, the control system is configured to control the lifting belt to release or wind to enable the grasping device to grasp a target object, and lift and transport the target object to a designated position in response to the target object being grasped by the grasping device.
